# FASCICULE DE BREVET EUROPEEN

(11) **EP 2 105 695 B1**
(45) Date de publication et mention de la délivrance du brevet: **27.04.2016**
(21) Numéro de dépôt: 09360006.2
(22) Date de dépôt: 14.01.2009
(51) Int. Cl.: F28D 7/00, F28F 27/00, G01R 33/31

(54) **Dispositif d'échangeur thermique et installation RMN comprenant un tel dispositif**
Wärmetauschervorrichtung und NMR-Anlage, die eine solche Vorrichtung umfasst
Heat-exchanger device and NMR installation comprising such a device

(30) Priorité: 21.01.2008 FR 0850371
(43) Date de publication de la demande: 30.09.2009
(73) Titulaire: Bruker Biospin SA, 67160 Wissembourg (FR)
(72) Inventeur: Krencker, Patrick, 67170 Brumath (FR); Podadera, Daniel, 67630 Niederlauterbach (FR)
(74) Mandataire: Nuss, Laurent

(56) Documents cités:
- EP-A- 1 655 616
- FR-A- 2 815 357
- ALLEN P J ET AL: "APPARATUS FOR LOW-TEMPERATURE MAGIC-ANGLE SPINNING NMR" JOURNAL OF MAGNETIC RESONANCE, ACADEMIC PRESS, ORLANDO, FL, US, vol. 92, no. 3, 1 mai 1991 (1991-05-01), pages 614-617, XP000203289 ISSN: 1090-7807

## Description

La présente invention concerne le domaine de la réfrigération, plus particulièrement la production de flux gazeux à basse température, et a pour objet un dispositif d'échangeur thermique, ainsi qu'une installation RMN utilisant un tel dispositif.

Dans de nombreux domaines techniques, et en particulier dans le domaine de la Résonance Magnétique Nucléaire (RMN), il est nécessaire de disposer de flux gazeux à basse température, c'est-à-dire notamment inférieur en température à 100 °K et en particulier proche de la température de l'azote liquide (77,3 °K).

Ces flux gazeux froids sont utilisés notamment pour refroidir l'échantillon à analyser et les parties d'équipement en contact avec ce dernier, ou pour les maintenir à basse température, mais également, le cas échéant, pour générer des actions mécaniques, statiques ou dynamiques.

Ainsi, en RMN (MAS) du solide, le tube à échantillon, appelé rotor, est en rotation rapide (à quelques KHz, voire quelques dizaines de KHz) lors de la phase de mesure, la rotation de l'échantillon permettant d'améliorer la qualité des spectres de mesure.

Il y a un grand intérêt pour effectuer des analyses MAS (Magic-Angle Spinnig) aux basses ou très basses températures pour différentes raisons scientifiques (transitions de phase, contrôle des réactions, etc.).

Les analyses MAS à basse température nécessitent des équipements spéciaux et des gaz très froids, préférentiellement dans le contexte actuel aussi proches que possible de la température de l'azote liquide (77,3 K).

De manière connue, les analyses RMN du type MAS sont généralement réalisées par l'intermédiaire d'une sonde comprenant une partie stator et une partie rotor, constitué par le tube à échantillon en rotation dans le stator.

On peut en particulier noter les points suivants en ce qui concerne la constitution et le fonctionnement d'une sonde MAS du type précité :
- présence de deux paliers à gaz (alimenté par un gaz appelé "bearing") qui supportent le tube à échantillon appelé rotor (lévitation gazeuse) ;
- la rotation du rotor est réalisée par un gaz appelé "drive" dont l'éjection sous pression au niveau d'une ou de plusieurs buse(s) entraîne une rotation plus ou moins rapide de l'échantillon placé dans le rotor (muni d'ailettes ou de formations analogues) ;
- la température de l'échantillon est contrôlée par un troisième gaz dénommé "VT".

A titre d'exemples chiffrés illustratifs des caractéristiques des flux gazeux mis en oeuvre actuellement au niveau d'une sonde RMN MAS, on peut indiquer :
- pression de gaz "bearing" de 2 à 4 bars/débit : jusqu'à 50 à 80 Nl/min ;
- pression de gaz "drive" de 1 à 2 bar/débit : 10 à 20 l/min typiquement (dépend de la vitesse de rotation) ;
- pression de gaz "VT" inférieure à 1 bar/débit : 30 l/min.

Dans la pratique, le gaz utilisé dans ces applications est, pour des raisons de coûts de revient, de confort d'utilisation et de limitation des risques, l'azote. Toutefois, d'autres types de gaz peuvent être envisagés, tels que l'argon, l'hélium, l'oxygène, ..., en fonction des applications et des températures à atteindre.

De manière classique, il est possible de produire très simplement des flux gazeux à basse température en faisant circuler ces derniers dans des serpentins ou des échangeurs plongés dans un bain de gaz liquide, avantageusement de même nature que le gaz circulant à refroidir.

Cette technique simple présente toutefois un inconvénient majeur, très préjudiciable dans les applications évoquées ci-dessus.

En effet, le refroidissement d'un gaz sous pression entraîne une condensation dudit gaz et, par conséquent, dans le serpentin ou conduit précité, la formation de gouttelettes de gaz liquide. De plus, le débit devient alors instable et il y a des fluctuations de pression.

Or, en particulier dans le contexte évoqué ci-dessus, il est extrêmement important de fournir un flux de gaz froid sec, c'est-à-dire dépourvu de gouttelettes, pour la réalisation des paliers qui maintiennent et guident le rotor en rotation.

En effet, si le gaz dit "bearing" subit une condensation entraînant la formation de gouttelettes, il en résulte un disfonctionnement majeur des paliers (du fait des fluctuations de pression générées). Ce disfonctionnement et les instabilités qu'il entraîne peuvent provoquer un contact physique entre le rotor et le stator susceptible d'endommager, voire de détruire, le tube à échantillon, avec pollution et/ou endommagement du stator, voire de la sonde.

Ainsi, le problème principal posé à la présente invention est de proposer un dispositif permettant de fournir au moins un flux de gaz froid sec, en particulier dans le contexte décrit précédemment et pour éviter les inconvénients susvisés.

La publication "Apparatus for Low-Temperature Magic-Angle Spinning NMR" ("Appareil pour la RMN basse température avec rotation à l'angle magique"), P.J. Allen et Al., Journal of Magnetic Resonance 92, 614-617 (1991), propose un dispositif d'échangeur thermique apte à délivrer au moins un flux de gaz sous pression et refroidi à une température sensiblement constante. Les flux de gaz circulent, au niveau du dispositif selon ce document, dans un serpentin ou un conduit analogue correspondant dont une partie fonctionnelle est plongée dans une fraction liquide d'un second gaz présent dans une chambre d'un contenant correspondant, la paroi du contenant délimitant ladite chambre étant en contact avec une fraction liquide d'un troisième gaz, de manière à constituer une surface de condensation pour le second gaz.

Le dispositif selon cette publication comprend en fait deux serpentins mutuellement imbriqués fournissant du gaz "bearing" et du gaz "drive", ces deux serpentins étant immergés dans un bain de gaz N2 liquide présent dans un contenant lui-même plongé dans un bain de N2 liquide.

Toutefois, cette publication n'évoque pas le problème de la fourniture de gaz sec, en particulier après changement du tube échantillon, et la pression interne du contenant est simplement contrôlée par un régulateur de pression. La construction de la chambre en cuivre peut produire un sous-refroidissement du gaz liquide du contenant, à l'arrêt, et entraîner la condensation du gaz circulant dans le serpentin.

La présente invention a donc pour objet un dispositif d'échangeur thermique apte à délivrer au moins un flux de gaz sec sous pression et refroidi à une température sensiblement constante, ledit au moins un flux de gaz circulant, au niveau du dispositif, dans un serpentin ou un conduit analogue correspondant dont une partie fonctionnelle est plongée dans une fraction liquide d'un second gaz présent dans une chambre d'un contenant correspondant, une portion au moins de la paroi du contenant délimitant ladite chambre étant en contact avec une fraction liquide d'un troisième gaz, de manière à constituer une surface de condensation pour le second gaz, dispositif caractérisé en ce que le ou chaque contenant est un contenant étanche apte à contenir le second gaz sous pression, en ce que la surface de condensation est dimensionnée pour permettre l'absorption d'une puissance calorique prédéterminée par le gaz contenu dans la chambre dudit contenant sans variation notable de sa température et de sa pression et en ce que le dispositif comprend également un moyen de chauffage variable contrôlé du bain formé par la fraction liquide du gaz résidant dans le contenant, la somme des puissances caloriques dégagée, d'une part, par le gaz circulant à refroidir et, d'autre part, par le moyen de chauffage étant maintenue constamment sensiblement égale à la puissance calorique déterminée précitée.

L'invention sera mieux comprise, grâce à la description ci-après, qui se rapporte à des modes de réalisation préféré, donnés à titre d'exemples non limitatifs, et expliqués avec référence aux dessins schématiques annexés, dans lesquels :
la figure 1 est une vue en coupe d'un dispositif d'échangeur thermique selon l'invention délivrant un seul flux de gaz refroidi ;
la figure 2 est une représentation schématique et de principe d'un dispositif d'échangeur thermique selon l'invention, avec ses moyens de contrôle, apte à délivrer trois flux de gaz refroidi et associé à une installation de RMN MAS ;
la figure 3 est une vue partiellement en coupe d'un mode de réalisation d'une partie du dispositif représenté schématiquement sur la figure 2 ;
les figures 4 et 5 sont des représentations partiellement en coupe des contenants étanches faisant partie du dispositif représenté sur la figure 3, ainsi que de leurs moyens de raccordement fluidique selon deux variantes de réalisation.

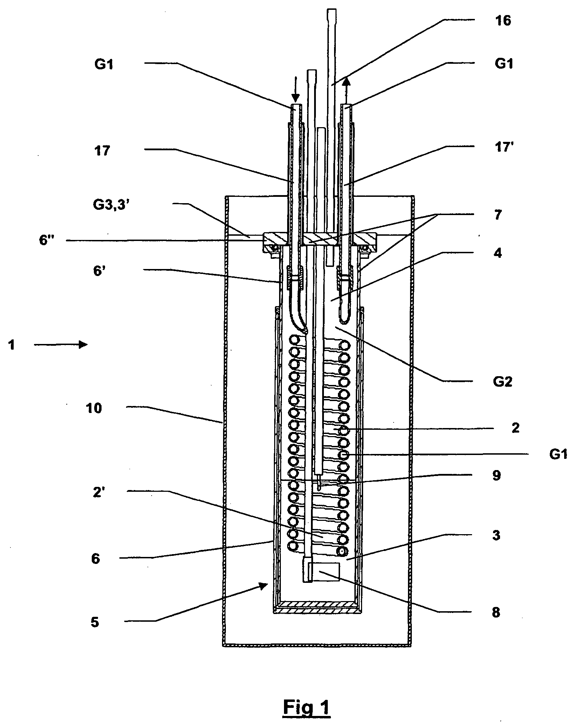

Les figures 1 à 5 montrent, au moins en partie, un dispositif 1 d'échangeur thermique apte à délivrer au moins un flux de gaz G1 sec sous pression et refroidi à une température sensiblement constante, ledit au moins un flux de gaz G1 circulant, au niveau du dispositif 1, dans un serpentin ou un conduit analogue 2 correspondant dont une partie fonctionnelle 2' est plongée dans une fraction liquide 3 d'un second gaz G2 présent dans une chambre 4 d'un contenant 5 correspondant. Une portion 6' au moins de la paroi 6 du contenant 5 délimitant ladite chambre 4 étant en contact avec une fraction liquide 3' d'un troisième gaz G3, de manière à constituer une surface de condensation 7 pour le second gaz G2, le cas échéant en coopération avec un couvercle ou bouchon de fermeture étanche 6".

Conformément à l'invention, le ou chaque contenant 5 est un contenant étanche apte à contenir le second gaz G2 sous pression. De plus, la surface de condensation 7 est dimensionnée pour permettre l'absorption d'une puissance calorique PC prédéterminée par le gaz G2 contenu dans la chambre 4 dudit contenant 5 sans variation notable de sa température et de sa pression. Le dispositif 1 comprend également un moyen 8 de chauffage variable contrôlé du bain formé par la fraction liquide 3 du gaz G2 résidant dans le contenant 5, la somme des puissances caloriques dégagée, d'une part, par le gaz G1 circulant à refroidir et, d'autre part, par le moyen de chauffage 8 étant maintenue constamment sensiblement égale à la puissance calorique PC déterminée précitée.

Le dimensionnement de la surface de condensation 7 est réalisé constructivement, pour des gaz G1, G2 et G3 de types donnés et des conditions de pression et de température données pour les gaz G2 et G3, de telle manière que même dans les conditions extrêmes de fonctionnement attendues pour le dispositif 1, c'est-à-dire avec des valeurs de débit, de pression et de différentiel de températures du gaz circulant G1 à refroidir entraînant un échange calorique maximal, le moyen de chauffage 8 est toujours alimenté, le cas échéant très faiblement.

De même, le moyen de chauffage 8 est dimensionné constructivement de telle manière qu'il puisse maintenir les conditions de température et de pression pour le gaz G2 résidant dans la chambre 4 en l'absence de toute circulation de gaz G1 à refroidir.

On réalise ainsi un contrôle positif des conditions régnant dans la chambre 4 dans n'importe quelles circonstances de fonctionnement prévisibles.

De même, le diamètre, la largeur et la configuration de la portion 2' du conduit ou serpentin 2 (préférentiellement à structure hélicoïdale) sont définis constructivement pour aboutir à un échange thermique optimisé, si possible avec un encombrement minimal.

Selon une caractéristique de l'invention, le dispositif 1 comprend également un moyen 9 de mesure de la température et/ou de la pression du gaz G2 résidant dans la chambre 4 du contenant étanche 5, à savoir un moyen de mesure de la température de la fraction liquide 3 de ce gaz G2 et/ou un moyen de la mesure de la pression de la fraction gazeuse dudit gaz G2.

Bien entendu, par action sur l'alimentation du moyen de chauffage 8 (du type résistance électrique située dans ou autour du contenant 5), il est possible d'ajuster manuellement le maintien de l'égalité entre puissances dégagées et puissance absorbée.

Toutefois, en accord avec une automatisation de cet ajustement, l'alimentation du moyen 8 de chauffage variable contrôlé, et donc la puissance calorique dégagée par ce dernier, est régulée en fonction de la température et/ou de la pression relevée par le(s) moyen(s) 9 de mesure correspondant(s), préférentiellement de manière à maintenir le gaz G2 résidant dans la chambre étanche 4 du contenant 5 dans un état d'ébullition.

Bien que différentes configurations en termes de combinaisons de gaz G1 et G2 soient possibles, notamment en fonction des applications et des températures requises, il est avantageusement prévu, pour des raisons de praticité, que le gaz circulant à refroidir G1 et le gaz G2 résidant dans la chambre 4 du contenant étanche 5 sont du même type, et consiste notamment en de l'azote, la pression interne dans ladite chambre 4 étant supérieure ou égale à la pression régnant dans le serpentin 2 ou analogue et les conditions de température et de pression dans la chambre 4 du contenant étanche 5 maintenant le gaz G2 y résidant en ébullition.

Conformément à une construction préférée du dispositif 1 selon l'invention, ressortant notamment des figures 1 et 3 à 5, le ou chaque contenant étanche 5 présente une paroi 6 thermiquement isolée à l'exception de la portion de paroi 6' définissant la surface de condensation 7 pour le gaz G2 résidant dans la chambre 4 (ou une partie de cette surface 7 lorsque le couvercle rapporté 6" contribue également à la condensation), cette portion de paroi 6' formant la ou étant située en partie supérieure du contenant 5, préférentiellement sans être en contact avec le bain 3 de gaz G2 liquide présent dans ladite chambre 4.

La fraction liquide 3 du gaz résidant G2 est par conséquent recueillie dans un réceptacle ne subissant sensiblement pas d'influence thermique extérieure et assurant une bonne stabilité thermique dudit bain 3.

En accord avec une réalisation pratique préférée, ressortant des figures 1 à 3 notamment, le ou chaque contenant étanche 5 est plongé en totalité dans un bain 3' de gaz G3 liquide, préférentiellement à pression atmosphérique et avantageusement de nature identique au gaz circulant à refroidir G1 et au gaz G2 résidant dans la chambre 4 dudit contenant 5, ledit ou chaque contenant étanche présentant avantageusement une structure générale sensiblement cylindrique avec une paroi 6 double à propriété d'isolation thermique (principe de vase de Dewar), à l'exception d'une partie supérieure à simple paroi 6' délimitant la surface 7 de condensation interne pour le gaz G2 résidant dans la chambre 4 dudit contenant 5 (la portion de paroi 6' est réalisée en un matériau bon conducteur thermique, tel que par exemple du métal), le cas échéant en combinaison avec le couvercle 6".

Le couvercle 6" fermant de manière étanche aux gaz le volume 4 peut, en fonction de sa conception et construction (à isolation thermique), et selon qu'il est ou non plongé dans le bain 3', participer ou non, éventuellement avec une contribution variable à la formation de la surface de condensation. Le cas échéant, la surface de condensation 7 peut n'être formée que par la portion de paroi 6', intégrant éventuellement une partie de fermeture extrémale formant couvercle 6" intégré.

On notera que les propriétés d'isolation de la paroi double 6 sont renforcées lorsque le contenant 5 correspondant est plongé dans le bain 3' de gaz G3 (vide poussé dans le volume interstitiel de la double paroi).

Lorsqu'un seul flux de gaz G1 refroidi est requis, le montage de la figure 1 peut être une réalisation adaptée.

Toutefois, lorsque la fourniture d'au moins deux flux différents de gaz G1 refroidi, de mêmes caractéristiques ou non, est requise, il est prévu selon l'invention que le dispositif 1 comprenne au moins deux contenants étanches distincts dans chacun desquels est monté un serpentin ou un conduit analogue 2 pour la circulation d'un gaz G1 à réfrigérer, lesdits contenants 5 étant tous plongés en totalité dans un même bain 3' de gaz G3 liquide présent dans un contenant commun 10 isolé thermiquement (par exemple du type vase de Dewar).

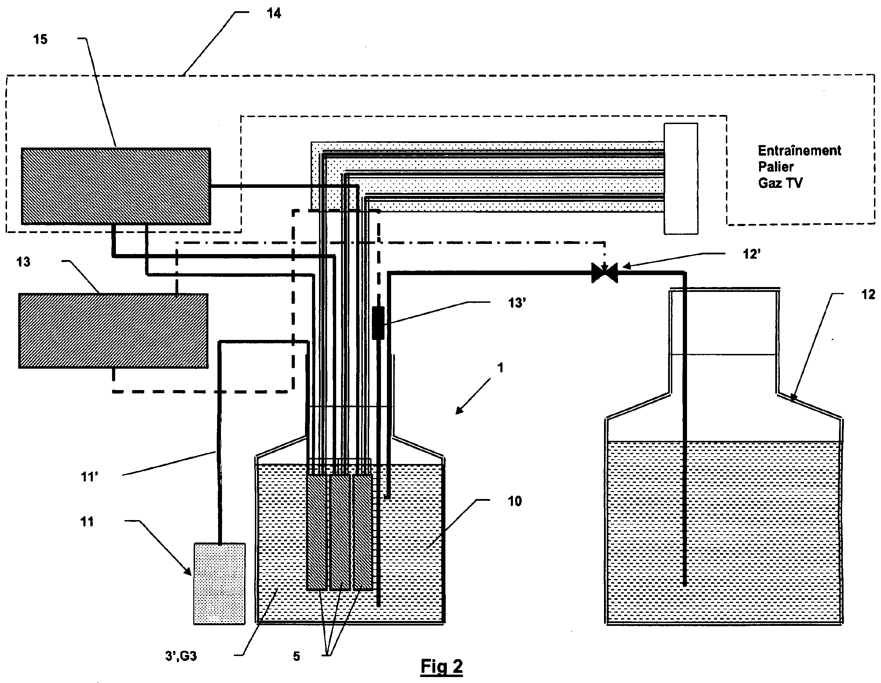

Dans le cas de l'application RMN MAS évoquée en introduction à la présente, le dispositif 1 est avantageusement prévu pour fournir trois flux de gaz refroidis distincts (Figure 2 - multiplication des contenants 5 de la figure 1).

Selon une première disposition optionnelle de l'invention, l'un au moins des paramètres d'état interne des différents contenants étanches 5, à savoir la température du bain 3 liquide et/ou la pression du gaz G2 résidant dans les chambres 4 desdits contenants 5, est différent d'un contenant à l'autre, ainsi qu'éventuellement les dimensions de leurs surfaces de condensation 7 respectives, les caractéristiques dimensionnelles ou la configuration des serpentins 2 et/ou les caractéristiques de leurs moyens de chauffage 8 respectifs.

Selon une seconde disposition optionnelle de l'invention, il peut éventuellement également être prévu que l'un au moins des paramètres du groupe comprenant la pression, la température avant refroidissement, la température après refroidissement et le débit, est différent pour les gaz G1 à refroidir circulant dans les serpentins ou conduits analogues 2 montés dans les différents contenants étanches 5, ce en fonction des sollicitations liées aux différentes applications des divers flux de gaz G1.

En accord avec une caractéristique additionnelle de l'invention ressortant schématiquement de la figure 2, chacun des contenants étanches 5 est relié à un réservoir 11 de gaz G2 sous pression correspondant par une ligne d'alimentation 11' et le contenant commun 10, recevant les différents contenants étanches 5, est alimenté en gaz depuis un réservoir 12 par une ligne 12' de transfert, sous le contrôle d'une unité de commande 13 recevant des signaux de mesure d'un capteur de niveau 13' associé audit contenant commun 10.

Pour des raisons de clarté de représentation, un seul réservoir 11 et une seule ligne 11' sont représentés sur la figure 2.

Ainsi, le dispositif 1 selon l'invention permet de fournir une source de gaz refroidi dont la température peut être contrôlée même lorsque le débit varie (dans les limites prédéterminées).

Ce principe peut être aisément démultiplié pour fournir plusieurs sources séparées ou indépendantes de gaz refroidi éventuellement de natures différentes et/ou présentant des températures de sortie, des pressions et/ou des débits différents (figure 2).

A l'appui des figures 1 à 5, une description plus détaillée d'une réalisation pratique non limitative de l'invention, en relation avec l'utilisation d'azote pour les trois gaz concernés G1, G2 et G3, est donnée ci-après, en limitant néanmoins la description à un seul contenant étanche (celle-ci pouvant être transposée à chacun des trois contenants 5 représentés sur les figures 2 à 5).

On rappelle tout d'abord que la fourniture d'un gaz froid G1 sec (sans gouttelettes), ici N₂, est réalisée simplement en plongeant un serpentin 2 échangeur, dans lequel circule ce gaz G1, dans de l'azote liquide dont la température est contrôlée.

A cette fin, la solution selon l'invention consiste à placer le serpentin 2 dans une chambre 4 délimitée par un contenant 5 sous pression contenant du LN₂ en ébullition. La température d'ébullition est déterminée par la pression du gaz régnant en surface du liquide.

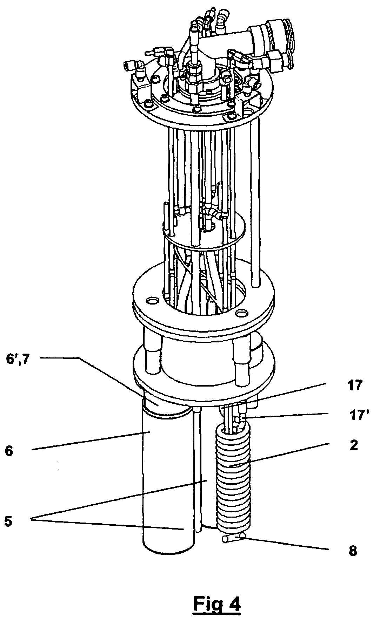

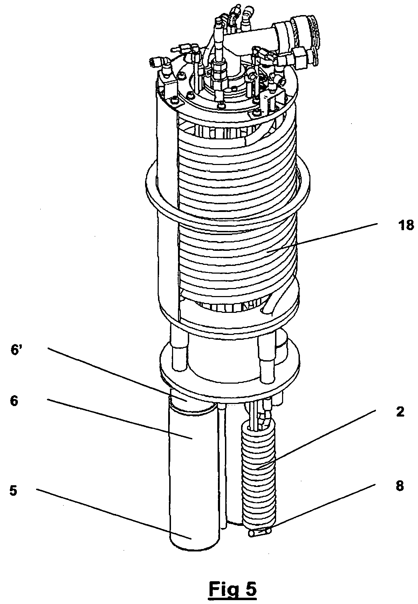

Comme cela ressort de la figure 1, et partiellement des figures 4 et 5, chaque contenant 5 comprend les éléments suivants :
- une chambre 4 étanche délimitée par une paroi en inox, dont la pression interne est contrôlée et dont la partie inférieure est isolée par une double paroi 6 en inox,
- un tube 16 de remplissage sous pression en gaz G2,
- un serpentin échangeur 2 avec une partie fonctionnelle 2' inférieure,
- un capteur 9 de température (PT100) traversant la partie supérieure de la chambre,
- une résistance 8 de chauffage (300W) traversant la partie supérieure de la chambre,
- une arrivée 12 de gaz G1 sous vide thermiquement isolée,
- une sortie 17' de gaz G1 sous vide thermiquement isolée.

A titre d'exemple, le volume de la chambre 4 contenant le serpentin échangeur 2 peut être de un litre environ. La chambre 4 est cylindrique et est fermée par un couvercle supérieur amovible fixé par des vis à une bride. L'étanchéité de la fermeture du couvercle est assurée par un joint métallique placé dans une gorge.

Comme indiqué précédemment, la pression interne de la chambre 4 est toujours supérieure ou égale à la pression du gaz à refroidir circulant dans le serpentin 2. De plus, le contenant 5 délimitant la chambre 4 est plongé entièrement dans un contenant ou réservoir 10 renfermant de l'azote liquide à pression atmosphérique (T=77,3K).

Lors du remplissage de chambre 4, on y injecte du gaz N₂ sous pression (par exemple sous 3 bars) à partir d'un réservoir 11 correspondant, la pression étant ajustée par un régulateur de pression.

Au fur et à mesure de l'injection de gaz dans la chambre 4, on assiste à une condensation dudit gaz au niveau d'une surface de condensation 7 formée par la partie supérieure 6' de la paroi de la chambre 4 (comprenant le couvercle) qui est en contact thermique avec l'azote liquide du réservoir 10 et la chambre 4 se remplit alors progressivement d'azote liquide formant un bain 3 recueilli dans la partie inférieure de la chambre 4.

Le capteur de température 9 dès qu'il est en contact avec l'azote liquide formant le bain 3 indique une température qui correspond à la température d'ébullition (T° fonction de P), cette température étant connue et constante.

On arrête alors le remplissage, le capteur 9 servant de capteur de niveau et étant monté à une position déterminée à cet effet.

Il convient de rappeler que l'aire de la surface de condensation 7 est calculée pour pouvoir condenser un peu plus que la puissance thermique dégagée par le gaz G1 circulant dans le serpentin 2, dans les circonstances de fonctionnement extrêmes.

Au débit maximal, le gaz chaud "bearing" dégage environ 300 W dans la chambre 4 et provoque une forte ébullition du bain 3'.

Le coefficient d'échange sur la surface de condensation 7 est, compte tenu de la portion de paroi 6' simple la formant, d'environ 1 500 à 2 000 W/m²-K et dépend de la pression interne dans la chambre 4.

Si la température d'ébullition est de 92 K, l'écart de température avec la paroi à 77,3 K est de 15 K environ.

En admettant un coefficient d'échange thermique de 2 000 W/m²-K et une puissance à évacuer de 300 W, il en résulte une surface de condensation 7 de P = h * S * DT, ce qui donne S = 0,01 m², soit 100 cm².

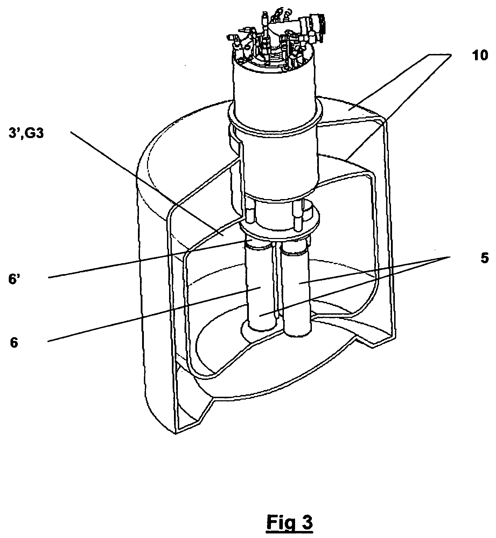

Dans le cadre d'une réalisation pratique conforme aux figures 3 à 5, la zone de condensation peut être constituée d'un segment cylindrique d'une hauteur de 4 cm et d'un diamètre de 5,5 cm, soit 69 cm².

A cette valeur, il faut ajouter la surface de la partie supérieure du couvercle, soit : surface de condensation du couvercle Pi x D²/4 - surface tube = 3,14 *(5,5 x 5,5) / 4 - 2 x (2*2/4)*3,14 = 23,7 - 6,2 cm² = 17,50 cm²

Ainsi, le gaz N₂ se condense sur la partie supérieure de la chambre 4 (portion de paroi simple 6' intégrant le couvercle) et retourne ensuite sous forme liquide au fond de la chambre. Le niveau interne d'azote liquide reste constant dans la chambre 4.

Lors de l'arrêt de fonctionnement du dispositif 1, il n'y a pas de circulation de gaz G1 dans le serpentin 2. Donc, aucune chaleur n'est injectée et l'ébullition s'arrête.

On compense alors l'absence de charge thermique en appliquant une puissance de chauffage complémentaire par l'intermédiaire de la résistance 8. Cette puissance est contrôlée par un régulateur électronique, éventuellement intégré à une unité de commande plus globale (commande de l'appareil RMN), qui mesure soit la température, soit la pression interne de la chambre 4 et régule la pression dans la chambre.

En l'absence de débit de gaz G1, on peut appliquer jusqu'à 300 watt pour maintenir la pression interne constante à 3,3 bars (soit une température d'ébullition de 92 K).

La puissance de chauffage délivrée par la résistance 8 dépend directement du débit de gaz G1 circulant dans le dispositif échangeur 1, sa valeur étant presque nulle quand le débit de gaz est maximal.

Cette réalisation selon l'invention permet de produire un gaz N₂ parfaitement sec. Lors de la montée en pression du circuit, on est toujours assuré qu'il n'y a pas formation de gouttelettes (le gaz est sec). Lors de la phase de démarrage, on monte progressivement la pression du gaz de zéro à la pression de fonctionnement.

Les raccordements tubulaires étanches et isolés thermiquement formant les arrivée et sortie 17 et 17' pour le gaz G1 à refroidir, peuvent éventuellement être prolongés par un dispositif 18 de prérefroidissement du flux de gaz G1 chaud avant son introduction dans la chambre 4, par les fuites de gaz G3 provenant du contenant 10 (Fig. 5 - structure à conduits concentriques).

Le capteur ou détecteur de niveau 13' peut par exemple être un capteur de niveau capacitif.

La présente invention a également pour objet une installation RMN 14 apte à réaliser des analyses du type MAS à basse température, en mettant en oeuvre un tube à échantillon en rotation rapide et supporté par des paliers à gaz, installation 14 caractérisée en ce qu'elle est alimentée en gaz formant les paliers, en gaz d'entraînement en rotation du tube à échantillon et en gaz de refroidissement de l'échantillon par un dispositif d'échangeur thermique 1 tel que décrit ci-dessus, éventuellement intégré à ladite installation 14.

Préférentiellement, l'unité 15 de commande et contrôle de ladite installation 14 commande le fonctionnement du dispositif d'échangeur thermique 1.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Dispositif d'échangeur thermique apte à délivrer au moins un flux de gaz sec sous pression et refroidi à une température sensiblement constante, ledit au moins un flux de gaz circulant, au niveau du dispositif, dans un serpentin ou un conduit analogue correspondant dont une partie fonctionnelle est plongée dans une fraction liquide d'un second gaz présent dans une chambre d'un contenant correspondant, une portion au moins de la paroi du contenant délimitant ladite chambre étant en contact avec une fraction liquide d'un troisième gaz, de manière à constituer une surface de condensation pour le second gaz, dispositif (1) **caractérisé en ce que** le ou chaque contenant (5) est un contenant étanche apte à contenir le second gaz (G2) sous pression, **en ce que** la surface de condensation (7) est dimensionnée pour permettre l'absorption d'une puissance calorique (PC) prédéterminée par le gaz (G2) contenu dans la chambre (4) dudit contenant (5) sans variation notable de sa température et de sa pression et **en ce que** le dispositif (1) comprend également un moyen (8) de chauffage variable contrôlé du bain formé par la fraction liquide (3) du gaz (G2) résidant dans le contenant, la somme des puissances caloriques dégagée, d'une part, par le gaz (G1) circulant à refroidir et, d'autre part, par le moyen de chauffage (8) étant maintenue constamment sensiblement égale à la puissance calorique (PC) déterminée précitée.

2. Dispositif selon la revendication 1, **caractérisé en ce qu'**il comprend également un moyen (9) de mesure de la température et/ou de la pression du gaz (G2) résidant dans la chambre (4) du contenant étanche (5), à savoir un moyen de mesure de la température de la fraction liquide (3) de ce gaz (G2) et/ou un moyen de la mesure de la pression de la fraction gazeuse dudit gaz (G2).

3. Dispositif selon la revendication 2, **caractérisé en ce que** l'alimentation du moyen (8) de chauffage variable contrôlé, et donc la puissance calorique dégagée par ce dernier, est régulée en fonction de la température et/ou de la pression relevée par le(s) moyen(s) (9) de mesure correspondant(s), préférentiellement de manière à maintenir le gaz (G2) résidant dans la chambre étanche (4) du contenant (5) dans un état d'ébullition.

4. Dispositif selon l'une quelconque des revendications 1 à 3, **caractérisé en ce que** le gaz circulant à refroidir (G1) et le gaz (G2) résidant dans la chambre (4) du contenant étanche (5) sont du même type, et consiste notamment en de l'azote, la pression interne dans ladite chambre (4) étant supérieure ou égale à la pression régnant dans le serpentin (2) ou analogue et les conditions de température et de pression dans la chambre (4) du contenant étanche (5) maintenant le gaz (G2) y résidant en ébullition.

5. Dispositif selon l'une quelconque des revendications 1 à 4, **caractérisé en ce que** le ou chaque contenant étanche (5) présente une paroi (6) thermiquement isolée à l'exception de la portion de paroi (6') définissant la surface de condensation (7) pour le gaz (G2) résidant dans la chambre (4), cette portion de paroi (6') formant la ou étant située en partie supérieure du contenant (5), préférentiellement sans être en contact avec le bain (3) de gaz (G2) liquide présent dans ladite chambre (4).

6. Dispositif selon l'une quelconque des revendications 1 à 5, **caractérisé en ce que** le ou chaque contenant étanche (5) est plongé en totalité dans un bain (3') de gaz (G3) liquide, préférentiellement à pression atmosphérique et avantageusement de nature identique au gaz circulant à refroidir (G1) et au gaz (G2) résidant dans la chambre (4) dudit contenant (5), ledit ou chaque contenant étanche présentant avantageusement une structure générale sensiblement cylindrique avec une paroi (6) double à propriété d'isolation thermique, à l'exception d'une partie supérieure à simple paroi (6') délimitant la surface (7) de condensation interne pour le gaz (G2) résidant dans la chambre (4) dudit contenant (5).

7. Dispositif selon l'une quelconque des revendications 1 à 6, **caractérisé en ce qu'**il comprend au moins deux, préférentiellement trois, contenants (5) étanches distincts dans chacun desquels est monté un serpentin ou un conduit analogue (2) pour la circulation d'un gaz (G1) à réfrigérer, lesdits contenants (5) étant tous plongés en totalité dans un même bain (3') de gaz (G3) liquide présent dans un contenant commun (10) isolé thermiquement.

8. Dispositif selon la revendication 7, **caractérisé en ce que** l'un au moins des paramètres d'état interne des différents contenants étanches (5), à savoir la température du bain (3) liquide et/ou la pression du gaz (G2) résidant dans les chambres (4) desdits contenants (5), est différent d'un contenant à l'autre, ainsi qu'éventuellement les dimensions de leurs surfaces de condensation (7) respectives, les caractéristiques dimensionnelles ou la configuration des serpentins (2), et/ou les caractéristiques de leurs moyens de chauffage (8) respectifs.

9. Dispositif selon l'une quelconque des revendications 7 et 8, **caractérisé en ce que** l'un au moins des paramètres du groupe comprenant la pression, la température avant refroidissement, la température après refroidissement et le débit, est différent pour les gaz (G1) à refroidir circulant dans les serpentins ou conduits analogues (2) montés dans les différents contenants étanches (5).

10. Dispositif selon l'une quelconque des revendications 7 à 9, **caractérisé en ce que** chacun des contenants étanches (5) est relié à un réservoir (11) de gaz (G2) sous pression correspondant par une ligne d'alimentation (11') et **en ce que** le contenant commun (10), recevant les différents contenants étanches (5), est alimenté en gaz depuis un réservoir (12) par une ligne (12') de transfert, sous le contrôle d'une unité de commande (13) recevant des signaux de mesure d'un capteur de niveau (13') associé audit contenant commun (10).

11. Installation RMN apte à réaliser des analyses du type MAS à basse température, en mettant en oeuvre un tube à échantillon en rotation rapide et supporté par des paliers à gaz, installation (14) **caractérisée en ce qu'**elle est alimentée en gaz formant les paliers, en gaz d'entraînement en rotation du tube à échantillon et en gaz de refroidissement de l'échantillon par un dispositif d'échangeur thermique (1) selon l'une quelconque des revendications 7 à 10, éventuellement intégré à ladite installation (14).

12. Installation selon la revendication 11, **caractérisé en ce que** l'unité (15) de commande et contrôle de ladite installation (14) commande le fonctionnement du dispositif d'échangeur thermique (1).

## Patentansprüche

1. Wärmetauschervorrichtung, geeignet, mindestens einen Strom trockenen, auf eine im Wesentlichen konstante Temperatur abgekühlten Druckgases abzugeben, wobei der genannte mindestens eine Gasstrom im Bereich der Vorrichtung in einer Rohrschlange oder einer ähnlichen Leitung zirkuliert, von der ein Funktionsteil in eine flüssige Fraktion eines zweiten Gases eingetaucht ist, das sich in einer Kammer eines entsprechenden Behälters befindet, wobei mindestens ein Teil der Wand des Behälters, die die genannte Kammer umgrenzt, mit einer flüssigen Phase eines dritten Gases in Berührung steht, derart, dass sie eine Kondensationsfläche für das zweite Gas bildet, Vorrichtung (1), **dadurch gekennzeichnet, dass** der oder jeder Behälter (5) ein dichter Behälter ist, der geeignet ist, das zweite Gas (G2) unter Druck zu enthalten, dadurch, dass die Kondensationsfläche (7) derart bemessen ist, dass sie die Absorption einer bestimmten Wärmeleistung (PC) durch das Gas (G2), das sich in der Kammer (4) des genannten Behälters (5) befindet, ohne erhebliche Temperatur- und Druckschwankungen ermöglicht und dadurch, dass die Vorrichtung (1) außerdem ein reguliertes, veränderbares Heizmittel (8) für das Bad umfasst, das aus der flüssigen Fraktion (3) des Gases (G2), das sich im Behälter befindet, besteht, wobei die Summe der einerseits vom abzukühlenden, zirkulierenden Gas (G1) und andererseits vom Heizmittel (8) abgegebenen Wärmeleistungen im wesentlichen konstant gleich der bestimmten, oben genannten Wärmeleistung (PC) gehalten wird.

2. Vorrichtung nach Patentanspruch 1, **dadurch gekennzeichnet, dass** sie außerdem ein Mittel (9) zur Messung der Temperatur und/oder des Druckes des Gases (G2), das sich in der Kammer (4) des dichten Behälters (5) befindet, umfasst, d.h. ein Mittel zur Messung der Temperatur der flüssigen Fraktion (3) dieses Gases (G2) und/oder ein Mittel zur Messung des Druckes der gasförmigen Fraktion des genannten Gases (G2).

3. Vorrichtung nach Patentanspruch 2, **dadurch gekennzeichnet, dass** die Versorgung des gesteuerten, veränderbaren Heizmittels (8) und damit die von diesem abgegebene Wärmeleistung in Abhängigkeit von der Temperatur und/oder dem Druck reguliert wird, der von dem/n entsprechenden Messmittel(n) gemessen wurde(n), vorzugsweise derart, dass sich das Gas (G2) in der dichten Kammer (4) des Behälters (5) im Siedezustand befindet.

4. Vorrichtung nach irgendeinem der Patentansprüche 1 bis 3, **dadurch gekennzeichnet, dass** das abzukühlende, zirkulierende Gas (G1) und das sich in der Kammer (4) des dichten Behälters (5) befindende Gas (G2) gleicher Art sind, insbesondere Stickstoff, wobei der Innendruck der genannten Kammer (4) größer oder gleich dem Druck in der Rohrschlange (2) oder Ähnlichem ist und die Temperatur- und Druckbedingungen in der Kammer (4) des dichten Behälters (5) das dort enthaltene Gas (G2) siedend halten.

5. Vorrichtung nach irgendeinem der Patentansprüche 1 bis 4, **dadurch gekennzeichnet, dass** der oder jeder dichte Behälter (5) eine wärmeisolierte Wand (6) aufweist, mit Ausnahme des Wandteils (6'), der die Kondensationsfläche (7) des in der Kammer (4) befindlichen Gases (G2) bildet, wobei dieser Wandteil (6') den oberen Teil des Behälters (5) bildet oder sich dort befindet, vorzugsweise ohne mit dem Bad (3) flüssigen Gases (G2) in der genannten Kammer (4) in Berührung zu sein.

6. Vorrichtung nach irgendeinem der Patentansprüche 1 bis 5, **dadurch gekennzeichnet, dass** der oder jeder dichte Behälter (5) vollständig in ein Bad (3') flüssigen Gases (G3), vorzugsweise bei Atmosphärendruck und vorteilhafterweise gleicher Art, wie das zirkulierende, abzukühlende Gas (G1) und das in der Kammer (4) des genannten Behälters (5) befindliche Gas (G2), eingetaucht ist, wobei der genannte oder jeder dichte Behälter vorteilhafterweise eine im Wesentlichen zylindrische Grundform mit einer doppelten Wand (6) mit Wärmeisolationseigenschaften hat, mit Ausnahme eines oberen Teils mit einfacher Wand (6'), der die innere Kondensationsfläche (7) für das Gas (G2) in der Kammer (4) des genannten Behälters (5) begrenzt.

7. Vorrichtung nach irgendeinem der Patentansprüche 1 bis 6, **dadurch gekennzeichnet, dass** sie mindestens zwei, vorzugsweise drei verschiedene dichte Behälter (5) umfasst, in deren jedem eine Rohrschlange oder eine ähnliche Leitung (2) für die Zirkulation eines abzukühlenden Gases (G1) montiert ist, wobei alle genannten Behälter (5) vollständig in dasselbe Bad (3') flüssigen Gases (G3) in einem gemeinsamen wärmeisolierten Behälter (10) eingetaucht sind.

8. Vorrichtung nach Patentanspruch 7, **dadurch gekennzeichnet, dass** mindestens einer der Parameter des Innenzustandes der verschiedenen dichten Behälter (5), d.h. die Temperatur des flüssigen Bades (3) und/oder der Druck des Gases (G2) in den Kammern (4) der genannten Behälter (5), von einem Behälter zum anderen verschieden ist, wie auch eventuell die Abmessungen ihrer jeweiligen Kondensationsflächen (7), die Kenngrößen der Abmessungen oder die Gestaltung der Rohrschlangen (2) und/oder die Kenngrößen ihrer jeweiligen Heizmittel (8).

9. Vorrichtung nach irgendeinem der Patentansprüche 7 und 8, **dadurch gekennzeichnet, dass** mindestens einer der Parameter der Gruppe, bestehend aus dem Druck, der Temperatur vor Abkühlung, der Temperatur nach Abkühlung und der Durchflussleistung, der abzukühlenden Gase (G1), die in den Rohrschlangen oder ähnlichen Leitungen (2) zirkulieren, die in den verschiedenen dichten Behältern (5) montiert sind, verschieden ist.

10. Vorrichtung nach irgendeinem der Patentansprüche 7 bis 9, **dadurch gekennzeichnet, dass** jeder der dichten Behälter (5) über eine Versorgungsleitung (11') mit einem entsprechenden Vorratsbehälter (11) für Gas (G2) unter Druck verbunden ist, und dadurch, dass der gemeinsame Behälter (10), der die verschiedenen dichten Behälter (5) aufnimmt, aus einem Behälter (12) über eine Durchgangsleitung (12') unter der Steuerung einer Steuereinheit (13) versorgt wird, die Messsignale eines Niveausensors (13') empfängt, der mit dem genannten gemeinsamen Behälter (10) verbunden ist.

11. NMR-Anlage, in der Lage, Analysen vom MAS-Typ bei tiefen Temperaturen auszuführen, wobei ein schnell rotierendes und von Gaslagern getragenes Probenrohr verwendet wird, wobei die Anlage (14), **dadurch gekennzeichnet ist, dass** sie mit Gas zur Ausbildung der Lager, mit Gas zum Antrieb der Rotation des Probenrohres und mit Gas zur Abkühlung der Probe durch eine Wärmetauschervorrichtung (1) nach irgendeinem der Patentansprüche 7 bis 10 versorgt wird, die eventuell in die genannte Anlage (14) eingebaut ist.

12. Anlage nach Patentanspruch 11, **dadurch gekennzeichnet, dass** die Einheit (15) zur Steuerung und Überwachung der genannten Anlage (14) den Betrieb der Wärmetauschervorrichtung (1) steuert.

## Claims

1. Heat exchanger device able to deliver at least one stream of dry gas under pressure and cooled to a substantially constant temperature, the said at least one stream of gas circulating, at the device, through a coil or a corresponding similar pipe a functional part of which is immersed in a liquid fraction of a second gas present in a chamber of a corresponding container, at least a portion of the wall of the container delimiting the said chamber being in contact with a liquid fraction of a third gas so as to constitute a condensation surface for the second gas, the device (1) being **characterized in that** the or each container (5) is a sealed container able to contain the second gas (G2) under pressure, **in that** the condensation surface (7) is dimensioned to allow the gas (G2) contained in the chamber (4) of the said container (5) to absorb a predetermined calorific power (PC) with no notable variation in its temperature and its pressure and **in that** the device (1) also comprises a means (8) for the controlled variable heating of the bath formed by the liquid fraction (3) of the gas (G2) residing in the container, the sum of the calorific powers released, on the one hand, by the circulating gas (G1) that is to be cooled and, on the other hand, by the heating means (8) being constantly kept substantially equal to the aforementioned determined calorific power (PC).

2. Device according to Claim 1, **characterized in that** it also comprises a means (9) of measuring the temperature and/or the pressure of the gas (G2) residing in the chamber (4) of the sealed container (5), namely a means of measuring the temperature of the liquid fraction (3) of this gas (G2) and/or a means of measuring the pressure of the gaseous fraction of the said gas (G2).

3. Device according to Claim 2, **characterized in that** the power supply to the variable controlled heating means (8) and, therefore, the calorific power released thereby, is regulated as a function of the temperature and/or of the pressure detected by the corresponding singular or plural measurement means (9), preferably so as to keep the gas (G2) residing in the sealed chamber (4) of the container (5) in a state of boiling.

4. Device according to any one of Claims 1 to 3, **characterized in that** the circulating gas that is to be cooled (G1) and the gas (G2) residing in the chamber (4) of the sealed container (5) are of the same type and notably consist of nitrogen, the internal pressure inside the said chamber (4) being greater than or equal to the pressure prevailing in the coil (2) or the like and the temperature and pressure conditions in the chamber (4) of the sealed container (5) keeping the gas (G2) residing therein at the boil.

5. Device according to any one of Claims 1 to 4, **characterized in that** the or each sealed container (5) has a wall (6) that is thermally insulated with the exception of the wall portion (6') that defines the condensation surface (7) for the gas (G2) residing in the chamber (4), this wall portion (6') forming the or being situated at the upper part of the container (5), preferably without being in contact with the bath (3) of liquid gas (G2) present in the said chamber (4).

6. Device according to any one of Claims 1 to 5, **characterized in that** the or each sealed container (5) is fully immersed in a bath (3') of liquid gas (G3), preferably at atmospheric pressure and advantageously identical in nature to the circulating gas that is to be cooled (G1) and to the gas (G2) residing in the chamber (4) of the said container (5), the said or each sealed container advantageously having an overall structure that is substantially cylindrical with a thermally insulating double wall (6), with the exception of a single-walled upper part (6') delimiting the internal condensation surface (7) for the gas (G2) residing in the chamber (4) of the said container (5).

7. Device according to any one of Claims 1 to 6, **characterized in that** it comprises at least two, preferably three, distinct sealed containers (5) in each of which a coil or a similar pipe (2) for the circulation of a gas (G1) that is to be refrigerated is mounted, the said containers (5) all being fully immersed in one and the same bath (3') of liquid gas (G3) present in a thermally insulated common container (10).

8. Device according to Claim 7, **characterized in that** at least one of the parameters regarding the internal state of the various sealed containers (5), namely the temperature of the liquid bath (3) and/or the pressure of the gas (G2) residing in the chambers (4) of the said containers (5) differs from one container to another, as potentially too do the dimensions of their respective condensation surfaces (7), the dimensional characteristics or the configuration of the coils (2) and/or the characteristics of their respective heating means (8).

9. Device according to either one of Claims 7 and 8, **characterized in that** at least one of the parameters of the group comprising the pressure, the temperature before cooling, the temperature after cooling and the flow rate, is different for the gases (G1) to be cooled circulating through the coils or similar pipes (2) mounted in the various sealed containers (5).

10. Device according to any one of Claims 7 to 9, **characterized in that** each of the sealed containers (5) is connected to a corresponding reservoir (11) of pressurized gas (G2) by a supply line (11') and **in that** the common container (10) housing the various sealed containers (5) is supplied with gas from a reservoir (12) by a transfer line (12') under the control of a command unit (13) receiving measurement signals from a level sensor (13') associated with said common container (10).

11. NMR installation capable of performing analyses of the low-temperature MAS type, using a rapidly spinning sample tube and supported by gas bearings, the installation (14) being **characterized in that** it is supplied with gas forming the bearings, with drive gas for spinning the sample tube and with gas for cooling the sample by a heat exchanger device (1) according to any one of Claims 7 to 10, possibly incorporated into the said installation (14).

12. Installation according to Claim 11, **characterized in that** the command and control unit (15) of the said installation (14) controls the operation of the heat exchanger device (1).
